(19) **Europäisches Patentamt European Patent Office Office européen des brevets**

(11) **EP 2 583 281 B1**

(12) **FASCICULE DE BREVET EUROPEEN**

(45) Date de publication et mention de la délivrance du brevet:
**15.08.2018 Bulletin 2018/33**

(21) Numéro de dépôt: **11729763.0**

(22) Date de dépôt: **16.06.2011**

(51) Int Cl.:
**G11C 11/16** (2006.01)       **G11C 11/14** (2006.01)
**G11C 11/56** (2006.01)       **H01L 27/20** (2006.01)

(86) Numéro de dépôt international:
**PCT/IB2011/052633**

(87) Numéro de publication internationale:
**WO 2011/158208 (22.12.2011 Gazette 2011/51)**

(54) **MÉMOIRE MAGNÉTOÉLECTRIQUE**

MAGNETOELEKTRISCHER SPEICHER

MAGNETORELECTRIC MEMORY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.06.2010 FR 1002580**

(43) Date de publication de la demande:
**24.04.2013 Bulletin 2013/17**

(73) Titulaires:
• **Centre National de la Recherche Scientifique
  75016 Paris (FR)**
• **Ecole Centrale De Lille
  59651 Villeneuve d'Ascq (FR)**

(72) Inventeurs:
• **TIERCELIN, Nicolas
  F-59000 Lille (FR)**
• **DUSCH, Yannick
  F-54300 Luneville (FR)**

• **PERNOD, Philippe Jacques
  F-59800 Lille (FR)**
• **PREOBRAZHENSKY, Vladimir
  F-59656 Villeneuve D'ascq (FR)**

(74) Mandataire: **Lavoix
  2, place d'Estienne d'Orves
  75441 Paris Cedex 09 (FR)**

(56) Documents cités:
**EP-A1- 1 318 523     EP-A1- 2 015 307**

• **TIERCELIN NICOLAS ET AL: "Magnetoelectric memory using orthogonal magnetization states and magnetoelastic switching", JOURNAL OF APPLIED PHYSICS, AMERICAN INSTITUTE OF PHYSICS. NEW YORK, US, vol. 109, no. 7, 1 avril 2011 (2011-04-01) , pages 7D726-1-7D726-3, XP012148562, ISSN: 0021-8979, DOI: 10.1063/1.3559532**

**Description**

L'invention porte sur une mémoire de type magnétoélectrique, et notamment sur une mémoire magnétoélectrique à accès direct. Plus précisément l'invention porte sur un élément de mémoire magnétoélectrique, sur une cellule de mémoire basée sur un tel élément, sur une mémoire comprenant une pluralité de telles cellules ainsi que sur un circuit logique programmable utilisant de telles cellules en tant que moyens de stockage d'une configuration logique. L'invention porte également sur un élément mémristif comprenant un élément magnétoélectrique.

Les mémoires non-volatiles sont des dispositifs électroniques d'une très grande importance. Elles peuvent être utilisées en particulier en tant que mémoires de masse, en remplacement des disques durs d'ordinateur, mais également pour stocker la configuration d'un composant numérique programmable tel qu'un réseau prédiffusé programmable par l'utilisateur (FPGA, de l'anglais « Field Programmable Gate Array »), en remplacement des mémoires volatiles (SRAM) utilisées actuellement dans la grande majorité de ces composants.

Une mémoire non volatile devrait présenter une densité de stockage élevée, des temps d'accès extrêmement rapides (équivalent à ceux d'une mémoire vive statique - SRAM - conventionnelle), une faible consommation et une durée importante de rétention de l'information. A présent, plusieurs technologies de mémoire sont en cours d'étude et de validation, à des stades de maturité différents. Parmi ces technologies, celles basées sur les effets de nature magnétique paraissent particulièrement prometteuses. Pour une revue de l'état actuel de développement des mémoires non-volatiles magnétiques on peut se rapporter à l'article de Mark H. Kryder et Chang Soo Kim, « After Hard Drives-What Comes Next? », IEEE Transactions on Magnetics, vol. 45, No. 10, pp. 3406-3413, octobre 2009.

La liste de technologies dressée par cette publication omet un principe qui suscite l'intérêt de nombreux laboratoires : les mémoires magnétoélectriques, dans lesquelles l'information, enregistrée sous une forme magnétique, serait écrite par une commande électrique de faible énergie, typiquement de type tension, et lue de façon magnétique. En principe, de telles mémoires pourraient exploiter des matériaux dits multiferroïques, possédant une phase ferroélectrique et une phase ferromagnétique couplées entre elles. La théorie prédit un faible nombre de ces matériaux possédant ces caractéristiques de façon intrinsèque, principalement en raison de conditions de symétrie cristallines contraignantes qu'il est nécessaire d'avoir pour que les deux effets « ferroélectrique » et « ferromagnétique » existent simultanément. Aucun matériau remplissant les bonnes conditions et possédant des effets suffisamment marqués à température ambiante n'existe à l'heure actuelle.

Une autre solution est la combinaison de matériaux magnétiques et ferroélectriques, ou plus généralement piézoélectriques ou électrostrictifs, couplés par le biais de contraintes mécaniques de manière à simuler un comportement multiferroïque.

L'article de V. Novosad et al. « Novel magnetostrictive memory device », J. Appl. Phys., Vol. 87, No. 9, 1er mai 2000, ainsi que le brevet US 6,339,543, décrivent une mémoire magnétoélectrique utilisant en tant qu'éléments de stockage de l'information des particules magnétiques de forme ellipsoïdale, de taille suffisamment petite pour ne consister que d'un seul domaine magnétique. En raison de leur anisotropie de forme, ces particules présentent deux orientations d'aimantation stables, opposées entre elles et alignées avec le grand axe de l'ellipse. Des lignes en matériau électrostrictif se croisant à 90° sont déposées sur un substrat, une particule magnétique étant positionnée au niveau de chaque croisement avec son grand axe orienté à 45° par rapport aux lignes. En appliquant aux lignes électrostrictives des signaux de tension adaptés, il est possible d'induire une contrainte mécanique tournante au niveau d'une particule déterminée ; par effet magnétoélastique inverse, cela induit à son tour une rotation de l'aimantation. Si leur temporisation et leur amplitude sont choisies d'une manière opportune, ces signaux de tension peuvent provoquer un basculement de l'aimantation de cette particule d'un état stable à l'autre.

Un tel dispositif présente plusieurs inconvénients. Premièrement il est très sensible à la synchronisation des signaux électriques, ce qui complique son pilotage et limite son temps de réponse ; cela est dû au fait que le champ de contraintes mécaniques doit tourner pour « guider » la rotation du vecteur d'aimantation. Deuxièmement, une opération d'écriture ne peut que retourner l'état d'aimantation d'une particule ; cela signifie que pour écrire un « 0 » ou un « 1 » dans une cellule de mémoire, il est nécessaire au préalable de lire son contenu pour déterminer si un tel retournement doit être effectué ou pas.

L'article de M. Overby et al. « GaMnAs-based hybrid multiferroic memory device », Applied Physics Letters 92, 192501 (2008) décrit une autre mémoire magnétoélectrique basée sur une couche épitaxiale de GaMnAs (semiconducteur magnétique) déposée sur un substrat en GaAs qui est aminci et fixé à un cristal piézoélectrique. La couche de GaMnAs présente deux axes d'aimantation facile, le long de directions cristallines respectives, qui correspondent à deux directions d'aimantation stables. L'application d'une contrainte mécanique, rendue possible par le cristal piézoélectrique, permet la commutation d'un état stable à l'autre. Un tel dispositif est complexe à fabriquer, car la connaissance des deux axes d'aimantation facile présuppose un contrôle fin des conditions de croissance épitaxiale. Par ailleurs, malgré l'application d'une contrainte mécanique, une barrière énergétique subsiste toujours entre les deux états stables : cela signifie que la commutation doit être assistée thermiquement, ou se vérifie par effet tunnel, ce qui est susceptible de limiter la vitesse de réponse de la mémoire. Le fonctionnement du dispositif n'a été démontré qu'à des températures cryogéniques.

L'invention vise à procurer une mémoire non-volatile de type magnétoélectrique ne présentant pas au moins certains des inconvénients de l'art antérieur.

Conformément à l'invention un tel but peut être atteint par un élément de mémoire magnétoélectrique comprenant :

- un élément magnétique présentant un seul axe d'aimantation facile aligné le long d'un premier axe ;
- un moyen pour appliquer audit élément magnétique un champ de polarisation magnétique aligné le long d'un deuxième axe non parallèle audit premier axe, l'intensité dudit champ étant choisie de telle manière que l'élément magnétique présente deux directions d'équilibre stable de son aimantation, ces directions n'étant pas opposées entre elles ;
- un substrat piézoélectrique ou électrostrictif couplé mécaniquement avec ledit élément magnétique ; et
- au moins une première et une deuxième électrode, agencées pour appliquer un champ électrique au substrat piézoélectrique ou électrostrictif de telle manière que ledit substrat exerce sur ledit élément magnétique une contrainte mécanique non isotrope, de direction principale généralement orientée selon un troisième axe, coplanaire mais distinct desdits premier et deuxième axes, ladite contrainte mécanique étant suffisamment intense pour induire une commutation de l'état d'aimantation dudit élément magnétique par couplage magnétostrictif.

Lorsqu'on dit que la direction principale de la contrainte mécanique est « généralement orientée selon un troisième axe » on entend mettre en évidence le fait que cette direction principale peut varier légèrement d'un point à l'autre de l'élément magnétique, le troisième axe correspondant à la direction moyenne.

Par « élément magnétique » on entend un élément réalisé en un matériau pouvant présenter un ordre magnétique même en l'absence d'un champ magnétique externe. Il peut notamment s'agir d'un élément ferromagnétique, ferrimagnétique, spérimagnétique voire même antiferromagnétique. Dans ce dernier cas, il n'y a pas d'aimantation macroscopique ; il y a néanmoins une direction d'alignement/antialignement des spins : il est donc possible de définir un « axe d'aimantation facile » et des états magnétiques stables. Tous les matériaux de ce type sont plus ou moins magnétostrictifs ; concrètement, cependant, il est opportun que le matériau constituant l'élément magnétique présente un coefficient magnétostrictif $b^{\gamma,2}$ relativement important, par exemple supérieur ou égal à 1Mpa et de préférence supérieur ou égal à 10 MPa, par exemple compris entre 10 et 100 MPa. Pour la définition du coefficient magnétostrictif il est possible de se rapporter aux articles suivants :

- E. du Trémolet de Lachaisserie, J. C. Peuzin « Magnétostriction and internal stresses in thin films: the cantilever method revisited », Journal of Magnetism and Magnetic Materials, Vol. 136, pp. 189 - 196 (1994) ; et
- E. du Trémolet de Lachaisserie « Définition and measurement of the surface magnetoelastic coupling coefficients in thin films multilayers », Phys. Rev. B, 51 (22), pp. 15925 - 15932 (1995).

Contrairement au dispositif décrit dans le brevet US 6,339,543 et dans l'article précité de V. Novosad et al, l'invention permet d'inscrire la valeur d'un bit sans avoir à connaître l'état présent de la mémoire. En outre, l'écriture se fait de manière simple et rapide, sans que se posent des problèmes de synchronisation entre plusieurs signaux de tension.

Contrairement au dispositif décrit par l'article précité de M. Overby et al., les deux états magnétiques stables de l'élément de mémoire ne sont pas obtenus en exploitant deux axes d'anisotropie du matériau magnétique, mais grâce à l'effet combiné d'un seul axe d'anisotropie (géométrique et/ou dû à la structure microscopique du matériau) et d'un champ de polarisation magnétique. Il en résulte un dispositif plus robuste, plus facile à fabriquer et offrant plus de flexibilité au concepteur. La barrière énergétique entre les deux états stables peut être complètement supprimée lors de la commutation.

On pourra également citer le document EP 2 015 307.

Selon d'autres caractéristiques avantageuses de l'invention, prises isolément ou en combinaison :

- Ledit élément magnétique peut être constitué d'un seul domaine magnétique.
- Ledit élément magnétique peut présenter une forme allongée (elliptique, rectangulaire, en losange...), déterminant en tout ou en partie ledit axe d'aimantation facile par anisotropie de forme. Ce mode de réalisation est particulièrement avantageux, car la direction et l'intensité de l'anisotropie peuvent être déterminées facilement, et indépendamment des propriétés intrinsèques du matériau.
- En variante ou en complément, ledit élément magnétique peut présenter une structure microscopique (mono- ou polycristalline, voire amorphe) anisotrope déterminant en tout ou en partie ledit axe d'aimantation facile. Avantageusement, ladite structure microscopique anisotrope peut être obtenue en fabriquant ledit élément par dépôt en présence d'un champ magnétique externe.
- L'élément de mémoire peut comporter un moyen pour générer ledit champ de polarisation magnétique sous la forme d'un champ magnétique externe : il peut s'agir d'une bobine ou d'un autre conducteur parcouru par un courant, d'un aimant permanent ou bien d'une couche de polarisation par champ de fuite.

- En variante ou en complément, ledit élément magnétique peut comporter un moyen pour générer ledit champ de polarisation magnétique sous la forme d'un champ d'échange. On comprendra que le champ de polarisation magnétique n'est donc pas nécessairement un champ magnétique au sens propre.
- L'élément de mémoire peut comporter un moyen pour générer un dit champ de polarisation magnétique sensiblement perpendiculaire audit axe d'aimantation facile (plus généralement, formant un angle de l'ordre de 80° - 100° avec ledit axe). Dans ce cas, lesdites électrodes peuvent être agencées de telle manière que ledit substrat exerce sur ledit élément magnétique une contrainte mécanique non isotrope formant un angle moyen compris entre 40° et 50°, et de préférence d'environ 45°, aussi bien avec ledit axe d'aimantation facile qu'avec ledit champ de polarisation magnétique.
- Lesdites électrodes peuvent épouser la forme de l'élément magnétique.
- Ledit élément magnétique peut être déposé sur ledit substrat.
- En variante, ledit élément magnétique peut être encastré dans ledit substrat. Cette variante convient particulièrement bien aux éléments magnétiques conducteurs.

Un autre objet de l'invention est une cellule de mémoire comprenant un élément de mémoire magnétoélectrique selon l'une des revendications précédentes et un capteur magnétique pour déterminer la direction de l'aimantation dudit élément magnétique. Ledit capteur peut notamment être choisi parmi : un capteur à effet Hall et un capteur à magnétorésistance, magnétorésistance à effet tunnel, magnétorésistance géante ou magnétorésistance colossale.

Encore un autre objet de l'invention est une mémoire non-volatile à accès direct comprenant une pluralité de telles cellules de mémoire agencées selon un schéma matriciel par lignes et par colonnes, les premières électrodes des cellules d'une même colonne étant reliées électriquement entre elles, ainsi que les deuxièmes électrodes des cellules d'une même ligne.

Encore un autre objet de l'invention est un circuit logique programmable comprenant une pluralité de telles cellules de mémoire en tant que moyen de stockage d'une configuration logique.

Encore un autre objet de l'invention est un dispositif mémristif comprenant :

- un élément magnétique présentant un seul axe d'aimantation facile aligné le long d'un premier axe ;
- un moyen pour appliquer audit élément magnétique un champ de polarisation magnétique aligné le long d'un deuxième axe non parallèle audit premier axe, l'intensité dudit champ étant choisie de telle manière que l'élément magnétique présente, par l'effet combiné dudit champ et dudit axe d'aimantation facile, deux états d'équilibre stable de son aimantation, correspondant à des directions d'aimantation formant entre elles un angle $0 \leq \alpha < 90°$;
- un substrat piézoélectrique ou électrostrictif couplé mécaniquement avec ledit élément magnétique ;
- au moins une première et une deuxième électrode, agencées pour appliquer un champ électrique au substrat piézoélectrique ou électrostrictif de telle manière que ledit substrat exerce sur ledit élément magnétique une contrainte mécanique non isotrope, de direction principale généralement orientée selon un troisième axe, coplanaire mais distinct desdits premier et deuxième axes ; et
- un capteur magnétique présentant deux terminaux, la résistance électrique entre les deux dits terminaux dépendant de la direction de l'aimantation dudit élément magnétique.

Avantageusement, les deux dits états d'équilibre stable de son aimantation peuvent coïncider, les directions d'aimantation correspondantes formant entre elles un angle $\alpha = 0°$.

D'autres caractéristiques, détails et avantages de l'invention ressortiront à la lecture de la description faite en référence aux dessins annexés donnés à titre d'exemple et qui représentent, respectivement :

- La figure 1, un schéma d'un élément de mémoire selon un mode de réalisation de l'invention ;
- La figure 2, un profil d'énergie magnétique de l'élément de mémoire de la figure 1 pour trois états de contrainte différents, mettant en évidence la commutation entre les deux états magnétiques d'équilibre ;
- la figure 3, une représentation géométrique des états magnétiques d'équilibre de l'élément de mémoire de la figure 1 ;
- Les figures 4A et 4B, le champ de contraintes mécanique dans l'élément magnétique de l'élément de mémoire de la figure 1 pour deux états de contrainte différents ;
- Les figures 5A à 5C, trois moyens de génération d'un champ de polarisation magnétique selon trois variantes de l'invention ;
- Les figures 6A et 6B, deux configurations admissibles de l'élément de mémoire de la figure 1 ;
- Les figures 6C et 6D, deux autres configurations de l'élément de mémoire de la figure 1, admissibles seulement à condition que l'élément magnétique ne soit pas conducteur ;
- Les figures 7A et 7B, respectivement, les surfaces équipotentielles dans un élément de mémoire selon un mode de réalisation de l'invention, et une géométrie possible des électrodes déterminée sur la base de ces surfaces équipotentielles ;

- La figure 8, une représentation schématique d'une mémoire non-volatile à accès direct selon un mode de réalisation de l'invention ;
- La figure 9, une représentation schématique d'un circuit logique programmable selon un mode de réalisation de l'invention ;
- La figure 10, une représentation schématique d'une mémoire non-volatile à accès direct selon un autre mode de réalisation de l'invention ;
- La figure 11, une représentation géométrique des états magnétiques d'équilibre de l'élément de mémoire de la figure 1 mettant en évidence la possibilité d'une utilisation à quatre états et d'une utilisation analogique ;
- Les figures 12, 13 et 14, trois cellules de mémoire selon différents modes de réalisation de l'invention, associant un élément de mémoire magnétoélectrique et un capteur magnétorésistif ; et
- Les figures 15A et 15B, deux modes de connexion possibles d'un dispositif mémristif selon un autre mode de réalisation de l'invention.

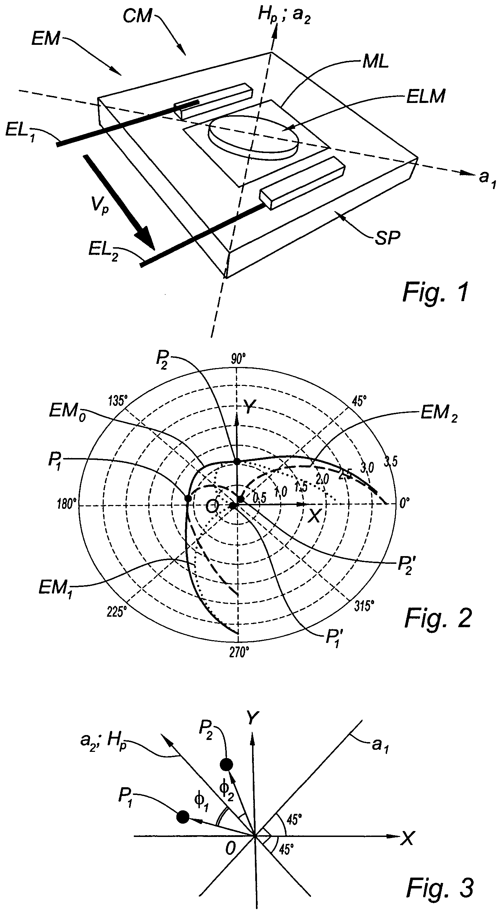

La géométrie d'une cellule de mémoire magnétoélectrique CM selon un mode de réalisation de l'invention est illustrée par la figure 1. La cellule de mémoire comprend un élément de mémoire ELM, présentant deux états stables et des moyens susceptibles d'induire une commutation entre ces états, et un moyen de lecture ML (ce dernier étant représenté de manière purement schématique).

L'élément de mémoire ELM se base sur un élément magnétique ELM de forme ellipsoïdale, de dimensions suffisamment petites pour assurer qu'il ne comprenne qu'un seul domaine magnétique ; par exemple, son plus grand axe peut présenter une longueur de l'ordre de 100 nm ou moins. Comme expliqué plus haut, par « élément magnétique » on entend un élément réalisé en un matériau pouvant présenter un ordre magnétique même en l'absence d'un champ magnétique externe, tel qu'un matériau ferromagnétique ou ferrimagnétique. De par sa forme, l'élément magnétique ELM possède une direction privilégiée de l'aimantation, appelée « axe d'aimantation facile », ou simplement « axe facile », suivant son grand axe. Cette direction d'aimantation facile est identifiée sur la figure par la référence $a_1$. On remarquera que cette anisotropie de forme ne fait pas de distinction entre le sens positif ou négatif de l'axe facile $a_1$.

Un champ magnétique de polarisation, indiqué par $H_p$, est appliqué selon une direction $a_2$ perpendiculaire à celle de l'axe d'aimantation facile $a_1$ ; dans le cas de l'exemple, cette direction $a_2$ est donc parallèle au petit axe de l'ellipse. Contrairement à l'anisotropie de forme selon $a_1$, le champ de polarisation favorise l'aimantation de l'élément ELM dans une direction parallèle au sens positif de l'axe $a_2$ et rend plus difficile son aimantation dans une direction opposée. L'intensité de ce champ est choisie comprise entre $\sqrt{2}/2$ et 1 fois l'intensité du champ magnétique équivalent caractérisant l'anisotropie de forme.

De manière conventionnelle on définit des axes X, Y formant un angle de 45° par rapport à $a_1$ et $a_2$ ; dans le système de coordonnées XOY (O étant l'origine) ainsi défini, l'axe $a_1$ est orienté selon la bissectrice du premier et du deuxième quadrant, et l'axe $a_2$ selon la bissectrice du deuxième et du troisième quadrant.

Sur la figure 2, la courbe $EM_0$ (en trait continu) montre, en coordonnées polaires, le profil de l'énergie magnétique du système, c'est à dire l'énergie magnétique stockée dans l'élément ELM en fonction de l'angle entre le vecteur d'aimantation et l'axe X. On peut voir que ce profil présente deux minimas d'énergie, c'est à dire deux orientations d'aimantation stables. Dans le cas particulier où l'axe $a_2$ et perpendiculaire à $a_1$ et l'intensité du champ $H_p$ vaut $\sqrt{2}/2$ fois l'intensité du champ magnétique équivalent caractérisant l'anisotropie de forme, ces orientations stables sont exactement dans les directions -X et Y. Ces orientations (ou « positions ») d'équilibre stable sont indiquées par les références $P_1$ et $P_2$. Elles sont séparées par une barrière énergétique. L'élément ELM constitue donc un élément bistable, susceptible de stocker un bit d'information : par exemple, un état d'aimantation selon l'orientation stable $P_1$ peut représenter un zéro logique et un état d'aimantation selon l'orientation stable $P_2$ un « un » logique, ou inversement.

La figure 3 montre de manière plus schématique l'orientation des axes $a_1$ et $a_2$ et des positions d'équilibre $P_1$, $P_2$. La figure 3 se rapporte au cas plus général où les orientations d'équilibre ne coïncident pas avec les axes -X et Y.

L'élément magnétique ELM est encastré dans un substrat piézoélectrique SP. Deux électrodes $EL_1$, $EL_2$ sont déposées sur (ou encastrées dans) ce substrat pour le polariser dans la direction OX. En fonction du signe du potentiel $V_p$ appliqué entre ces deux électrodes, le substrat piézoélectrique SP génère une contrainte mécanique $\sigma_{XX}$ en compression ou en traction dont la direction principale est orientée dans la direction OX, qui est appliquée à l'élément magnétique ELM. Ce dernier présente un effet magnétoélastique : par conséquent, la contrainte mécanique $\sigma_{XX}$ modifie le profil de l'énergie magnétique du système.

Afin d'augmenter la contrainte appliquée à l'élément magnétique, pour une différence de potentiel $V_p$ donnée, il peut être avantageux d'entourer le dispositif d'un matériau à haut module d'élasticité, tel que le AIN (300 GPa), le TaN (>500 GPa), le carbure de tungstène WC (>700 GPa) ou le diamant (>1400 GPa) - à titre de comparaison, les céramiques PZT présentent un module d'élasticité inférieur à 100 GPa.

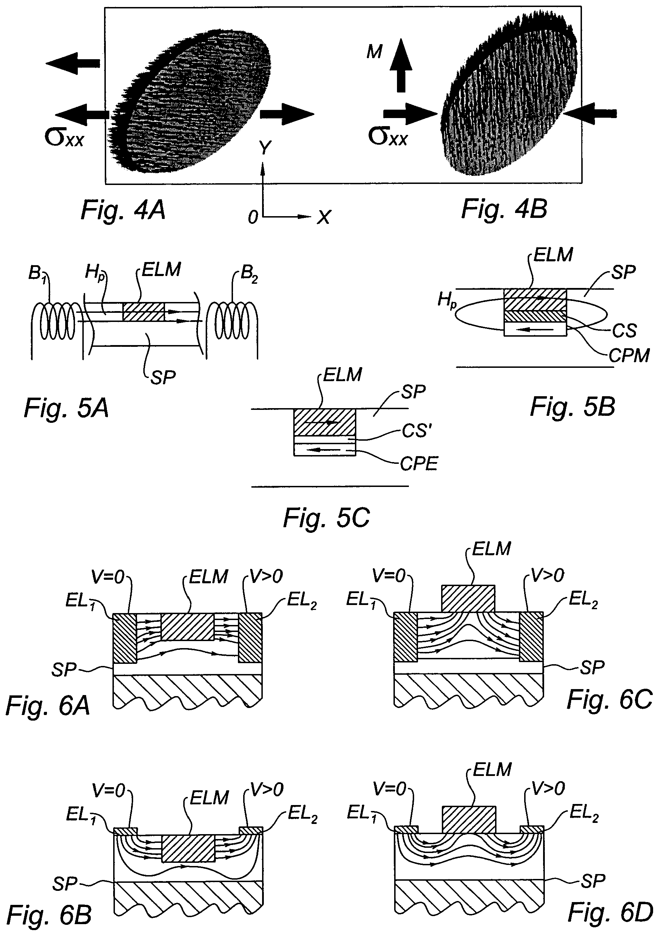

Sur la figure 2, la courbe en trait pointillé $EM_1$ illustre le profil d'énergie magnétique du système en présence d'une contrainte mécanique $\sigma_{XX}$ en traction. On peut voir qu'il y a un seul point d'équilibre stable $P'_1$, correspondant à une aimantation orientée dans la direction -X. La situation est illustrée également sur la figure 4A, où la référence M indique le vecteur d'aimantation. On comprend qu'après relâchement des contraintes (lorsque $V_p$ reprend une valeur nulle) le système se trouve nécessairement dans l'état $P_1$, indépendamment de son état initial (avant l'application de la différence de potentiel $V_p$).

Toujours sur la figure 2, la courbe en trait hachuré $EM_2$ illustre le profil d'énergie magnétique du système en présence d'une contrainte mécanique $\sigma_{XX}$ en compression. On peut voir qu'il y a un seul point d'équilibre stable $P'_2$, correspondant à une aimantation orientée dans la direction +Y. La situation est illustrée également sur la figure 4B. On comprend qu'après relâchement des contraintes (lorsque $V_p$ reprend une valeur nulle) le système se trouve nécessairement dans l'état $P_2$, indépendamment de son état initial (avant l'application de la différence de potentiel $V_p$).

On a donc montré que l'application d'un signal électrique $V_p$ aux électrodes $EL_1$, $EL_2$ permet de modifier l'état d'aimantation de l'élément ELM. L'état d'aimantation de ce dernier, et donc la valeur du bit stocké par la cellule de mémoire, dépend seulement du signe de $V_p$, et pas de l'état avant application du signal. La cellule de mémoire peut donc être écrite sans qu'il soit nécessaire de la lire au préalable.

Des simulations ont montré que le temps de commutation de la cellule de mémoire est d'autant plus court que la contrainte mécanique appliquée est élevée. Ainsi, il existe un lien entre consommation énergétique (liée à l'intensité de la contrainte mécanique) et rapidité d'écriture. On peut donc choisir de maximiser cette rapidité, au prix d'une consommation relativement élevée, ou bien de minimiser la consommation énergétique au prix d'une commutation plus lente, ou bien chercher un compromis entre ces deux exigences opposées.

La vitesse de commutation peut, optionnellement, être augmentée par l'application, simultanément à la contrainte mécanique, d'un champ magnétique transitoire, orienté dans la direction de $P_1$ ou de $P_2$.

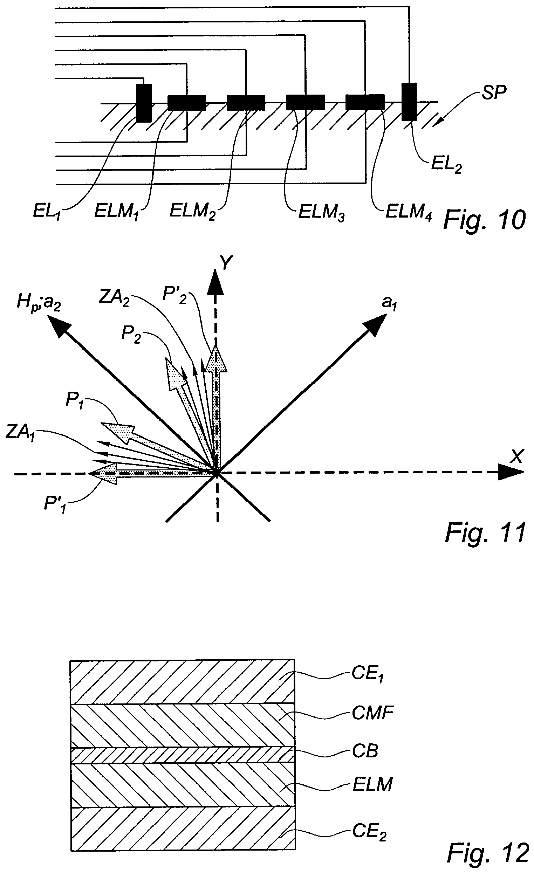

Un dispositif selon l'invention peut être utilisé comme dispositif bistable, présentant uniquement deux états stables, $P_1$ et $P_2$. Cependant, lorsque ces deux états ne correspondent pas à des directions d'aimantation perpendiculaires entre elles, un fonctionnement à quatre états est possible, pour enregistrer deux bits dans un seul élément de mémoire. Les quatre états sont $P'_1$ (aimantation le long de l'axe -X, obtenue par l'application d'une contrainte en traction d'intensité maximale), $P_1$ (état stable en l'absence de contrainte mécanique), $P_2$ (état stable en l'absence de contrainte mécanique) et $P'_2$ (aimantation le long de l'axe Y, obtenue par l'application d'une contrainte en compression d'intensité maximale) ; cette situation est illustrée sur la figure 11. Autrement dit, les états $P'_1$ et $P'_2$ peuvent être utilisés comme états stables de l'élément de mémoire, et pas uniquement comme états intermédiaires atteints de manière transitoire au cours d'une commutation. On comprend que ce fonctionnement à quatre états est volatile, car les états $P'_1$ et $P'_2$ ne peuvent être maintenus indéfiniment en l'absence d'alimentation, car le condensateur formé par les électrodes $EL_1$ et $EL_2$ tend à se décharger. On comprend que les états $P'_1$ et $P'_2$ sont maintenus tant que le condensateur formé par les électrodes $EL_1$ et $EL_2$ reste chargé. Il est donc avantageux de concevoir l'élément de mémoire de manière à minimiser les courants de fuite tendant à décharger ce condensateur.

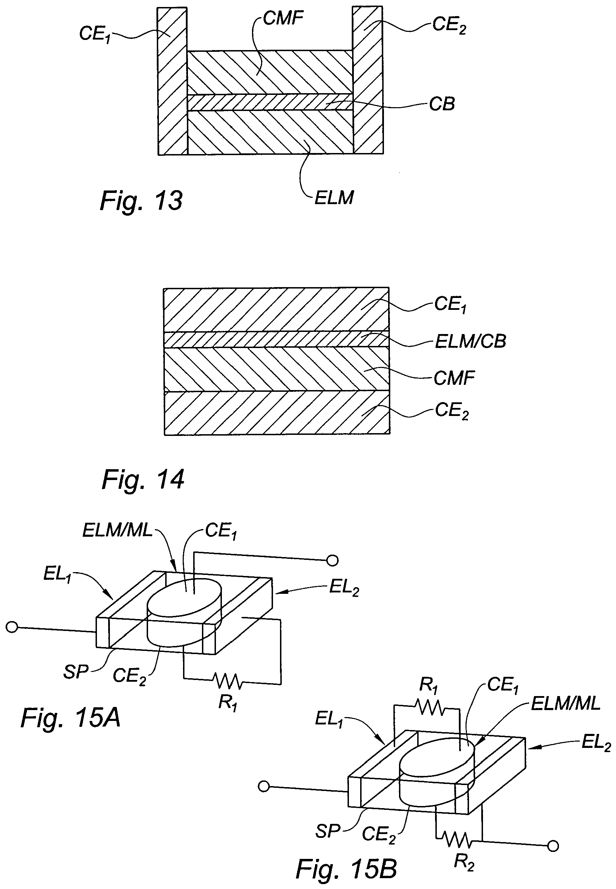

En partant de l'état $P'_1$ et en faisant diminuer progressivement l'intensité de la contrainte en traction, l'aimantation tourne progressivement vers la direction identifiée par l'état $P_1$, définissant ainsi une première zone de fonctionnement analogique $ZA_1$. De même, en partant de l'état $P'_2$ et en augmentant progressivement la contrainte en compression, on peut fait tourner l'aimantation vers la direction identifié par l'état $P_2$, définissant ainsi une deuxième zone de fonctionnement analogique $ZA_2$. Dans les zones de fonctionnement analogique, l'orientation de l'aimantation dépend de manière continue de la contrainte, et donc de la tension appliquée au substrat piézoélectrique, c'est-à-dire de l'état de charge du condensateur formé par les électrodes $EL_1$ et $EL_2$. Si, comme cela sera expliqué en détail plus loin, l'élément magnétique est couplé à un capteur magnétorésistif, par exemple du type à magnétorésistance géante, alors la résistance $R_c$ de ce capteur dépend de l'orientation de l'aimantation de l'élément ELM et donc, indirectement, de la charge Q stockée dans le condensateur $EL_1$ - $EL_2$: $R_c = f(Q)$. L'ensemble constitué par l'élément ELM, le substrat piézoélectrique SP, les électrodes $EL_1$, $EL_2$ et le capteur magnétorésistif ML présente donc un comportement de type « mémristif », plus complexe qu'un simple « mémristor » car présentant quatre terminaux (les deux électrodes $EL_1$, $EL_2$ et les deux bornes $CE_1$, $CE_2$ du capteur magnétorésistif - voir les figures 12 à 14). En reliant entre eux les terminaux $EL_2$ et $CE_2$ à travers une résistance $R_1$ on obtient un dispositif à deux terminaux pouvant être modélisé, en première approximation, par un mémristor connecté en série à un condensateur et à une résistance ; cette connexion est représentée schématiquement sur la figure 15A. En reliant $EL_1$ avec $CE_1$ à travers une première résistance $R_1$ et $EL_2$ avec $CE_2$ (ou $EL_1$ avec $CE_2$ et $EL_2$ avec $CE_1$) à travers une deuxième résistance $R_2$ on obtient un autre dispositif à deux terminaux pouvant être modélisé, en première approximation, par un mémristor (en série avec une résistance $R_{tot}=R_1+R_2$) connecté en parallèle à un condensateur ; cette connexion est représentée schématiquement sur la figure 15B.

Si l'on souhaite exploiter le comportement mémristif du dispositif, il peut être avantageux de choisir un champ de polarisation $H_p$ d'intensité supérieure ou égale à celle du champ magnétique équivalent caractérisant l'anisotropie de forme, de telle sorte que $P_1$ et $P_2$ viennent à coïncider, et les zones de fonctionnement analogique $ZA_1$ et $ZA_2$ se rejoignent. Dans ces conditions, la résistance du capteur magnétorésistif varie de manière continue lorsque la charge stockée dans le condensateur $EL_1$ - $EL_2$ varie de - $Q_{max}$ à +$Q_{max}$. On comprend qu'un tel dispositif, présentant un seul état d'aimantation stable en l'absence de contrainte appliquée (ou, ce qui est équivalent, deux états dégénérés, caractérisés par deux directions d'aimantation identiques) ne peut pas être utilisé comme mémoire non-volatile.

Un moyen de lecture ML est représenté de manière schématique sur la figure 1. Il peut s'agir de tout type de capteur magnétique, par exemple du type à effet Hall, à magnétorésistance, magnétorésistance à effet tunnel, magnétorésistance géante ou magnétorésistance colossale. Il peut être intégré ou discret. En général, la lecture n'est pas destructive.

L'utilisation d'un capteur magnétorésistif de type à magnétorésistance géante (GMR) ou à jonction tunnel magnétique (MTJ) est particulièrement préférée. D'une manière générale, ces capteurs associent une couche magnétique à aimantation variable et une couche dont l'aimantation reste fixe, ces deux couches étant séparées par une couche barrière qui peut être conductrice (cas de l'effet GMR) ou isolante (cas de l'effet MTJ).

La figure 12 illustre le cas d'un capteur GMR ou MTJ du type « à courant perpendiculaire au plan » (CPP). Dans ce cas, l'élément magnétique ELM est conducteur et joue le rôle de couche magnétique à aimantation variable. La référence CMF indique la couche dont l'aimantation reste fixe, et CB la couche barrière, d'épaisseur nanométrique, qui peut être conductrice (cas de l'effet GMR) ou isolante (cas de l'effet MTJ). Cet empilement de couches est enserré entre deux contacts électriques ou terminaux $CE_1$, $CE_2$.

La figure 13 illustre une architecture alternative, dite à « courant dans le plan » (CIP), dans laquelle la résistance de l'empilement de couches ELM/CB/CMF est mesurée dans sur la tranche dudit empilement. Cette architecture présuppose une couche barrière conductrice, et donc un fonctionnement de type GMR.

Lorsque l'élément magnétique ELM n'est pas conducteur, on peut utiliser une architecture MTJ de type CPP sans couche barrière - ou plutôt dans laquelle l'élément ELM joue à la fois le rôle de couche magnétique et de couche barrière - comme illustré sur la figure 14. L'épaisseur de cet élément ELM doit être alors de l'ordre du nanomètre et par exemple d'environ 2 nm. Il est difficile d'appliquer une contrainte mécanique sur la tranche d'une couche aussi mince ; ainsi, la contrainte sera de préférence appliqué à tout l'empilement.

Dans tous les cas, la résistance électrique mesurée entre $CE_1$ et $CE_2$ dépend de l'angle $\alpha$ formé par les directions d'aimantation de l'élément ELM de la couche fixe CMF, et prend sa valeur minimale pour un angle nul (aimantations parallèles) et sa valeur maximale pour un angle de 180° (aimantations antiparallèles).

Dans le cas de l'architecture GMR-CPP de la figure 12, la résistance $R_c$ mesurée entre les contacts $CE_1$ et $CE_2$ est donnée, selon un modèle phénoménologique, par une équation de la forme :

$$R_c = a - b \cdot \cos^2\left(\alpha / 2\right) + c \cdot \cos^4\left(\alpha / 2\right)$$

où a, b et c sont des constantes positives qui dépendent de différentes caractéristiques du dispositif. Pour une direction donnée de l'aimantation de la couche CMF, $R_c$ dépend de l'état $P_1$ ou $P_2$ dans lequel se trouve l'élément CEM ; on a donc deux valeurs de résistance, $R_c(P_1)$ et $R_c(P_2)$. L'équation ci-dessus peut donc être utilisée pour trouver la direction de l'aimantation de la couche CMF qui maximise le contraste de résistance $C_R = |(R_c(P2)-R_c(P1))/R_c(P1)|$.

Dans le cas d'une architecture MTJ-CPP (figure 12 ou 14), la conductance $G_c$ mesurée entre les contacts $CE_1$ et $CE_2$ est donnée, également selon un modèle phénomènologique, par une équation de la forme :

$$G_C = G_p \cdot \cos^2\left(\alpha / 2\right) + G_{ap} \cdot \sin^2\left(\alpha / 2\right)$$

où $G_p$ et $G_{ap}$ sont les conductances de la jonction tunnel pour des aimantations parallèles et antiparallèles, respectivement. Là encore, on peut se servir de l'équation pour déterminer la direction de l'aimantation de la couche CMF qui maximise le contraste de résistance $R_c = 1/G_c$.

Dans le cas de l'architecture GMR-CIP on a :

$$R_c = a - b \cdot \cos\left(\alpha\right)$$

On vérifie facilement que le contraste de résistance est maximal lorsque les états $P_1$ et $P_2$ correspondent à des directions d'aimantation perpendiculaires entre elles, dont l'une coïncide avec la direction de l'aimantation de la couche CMF.

Les équations ci-dessus montrent que la résistance (conductance) est une fonction paire de l'angle $\alpha$ entre les aimantations. Cela signifie que si l'aimantation de la couche fixe est dans la direction du champ de polarisation $H_p$, et donc à mi-chemin entre les deux positions d'équilibre $P_1$ et $P_2$, la résistance (conductance) obtenue est la même pour les deux états de l'élément de mémoire, donc le contraste est nul, ce qui ne permet pas la lecture de l'information (on laisse de coté, pour le moment, le cas où les directions identifiée par $P_1$ et $P_2$ ne sont pas symétriques par rapport à $H_p$).

Cela pose une double difficulté :

- d'une part, le champ magnétique de fuite généré par la couche CMF se superpose au champ de polarisation $H_p$, modifiant les positions d'équilibre de l'élément magnétique ;
- d'autre part, le champ de polarisation $H_p$ peut avoir tendance à modifier l'état d'aimantation de la couche « fixe ».

Il existe plusieurs solutions pour remédier à cette difficulté. Par exemple :

- Le champ de polarisation $H_p$ peut ne pas être un champ magnétique, mais un champ effectif traduisant l'effet d'une interaction d'échange avec une couche mince (typiquement de l'ordre de 2 nm) de matériau antiferromagnétique déposée sur - ou sous - l'élément ELM. Les interactions d'échange sont de faible portée, donc elles ne perturbent pas l'aimantation de la couche CMF, trop éloignée. Quant à l'effet du champ de fuite généré par ladite couche, il peut être compensé en choisissant de manière opportune la direction et l'intensité du champ effectif $H_p$.
- Réciproquement, l'état d'aimantation de la couche CMF peut être maintenu constant par couplage d'échange avec une couche antiferromagnétique. La force de ce couplage rend la couche CMF insensible au champ de polarisation $H_p$ (de nature magnétique) tandis que sa faible portée évite que l'état d'aimantation de l'élément ELM soit affecté.
- Les deux approches peuvent être combinées, deux couches antiferromagnétiques distinctes étant utilisées pour créer un champ de polarisation effectif $H_p$ et pour fixer l'aimantation de la couche CMF. Toutefois, cette solution est difficile à mettre en oeuvre pour des raisons technologiques.
- La couche CMF peut, tout comme l'élément ELM, présenter un axe d'aimantation facile (de nature géométrique ou autres), qui coopère avec le champ de polarisation pour déterminer deux états stables d'aimantation, mais ne pas être magnétostrictive (ou l'être beaucoup moins que l'élément ELM, ou encore présenter une anisotropie plus forte). Dans ces conditions, l'application d'une contrainte mécanique provoque une commutation de l'état d'aimantation dans l'élément ELM, mais pas dans la couche CMF. L'intérêt de cette approche est que le champ de polarisation $H_p$ ne perturbe pas l'état d'aimantation de la couche CMF, au contraire il contribue à sa stabilité. Par contre, dans le dimensionnement du dispositif il faut tenir compte du fait que le champ magnétique de fuite généré par CMF influence ELM, et réciproquement.
- La couche CMF peut être constituée d'un matériau à très forte anisotropie magnétocristalline, de type aimant permanent, dont l'aimantation est pratiquement insensible au champ de polarisation $H_p$. Par contre, dans le dimensionnement du dispositif il faut tenir compte du champ magnétique de fuite générée par cette couche, qui est susceptible d'affecter l'aimantation de l'élément magnétique ELM se superposant à $H_p$.
- Si le champ de polarisation $H_p$ n'est pas perpendiculaire à l'axe d'aimantation facile de l'élément ELM, alors les positions d'équilibre $P_1$ et $P_2$ sont dissymétriques par rapport audit champ. Dans ces conditions, il existe un contraste de résistance même si l'aimantation de la couche CMF est parallèle à $H_p$. Cependant, ce contraste risque d'être relativement faible.

Afin de valider le concept et sa faisabilité, des simulations par éléments finis ont été réalisées pour évaluer les contraintes générées, et leur effet sur l'aimantation de l'élément magnétique. Les simulations pour évaluer les contraintes ont été effectuées avec les paramètres suivants :

Taille de l'élément magnétique : grand axe : 45nm, petit axe: 25nm, épaisseur : 20nm, orientation 45°.
Distance inter électrodes : 130nm.
Longueur des électrodes : 120nm.
Hauteur des électrodes : 50nm.

Matériau des électrodes et de l'élément magnétique : caractérisé par un module d'Young de 110 GPa.

Épaisseur du matériau piézoélectrique : 60nm.
Substrat piézoélectrique : titanate-zirconate de plomb, dit PZT-5H, encastré à la base.

Pour une tension de commande de -0,4V, l'allongement relatif suivant OX de l'élément magnétique est d'environ $1,2.10^{-3}$ et la contrainte tensile est supérieure a 100 Mpa. Réciproquement, pour une tension de commande de +0,4V, l'allongement relatif de l'élément magnétique est d'environ -1,2.10-3.

Dans le substrat piézoélectrique, la valeur maximale du champ électrique n'excède pas 10 MV/m, ce qui est compatible avec la plupart des matériaux piézoélectriques usuels, pour lesquels le champ disruptif est typiquement de l'ordre de 50 MV/m. La marge de manoeuvre permet d'envisager une réduction de la taille de la cellule : la baisse de dimension de la partie piézoélectrique active peut être compensée par une augmentation de la tension de commande, tout en restant dans les limites de fonctionnement du matériau.

Des simulations magnétiques ont aussi été effectuées en considérant un élément magnétique en Terfenol ($Tb_{0,3}Dy_{0,7}Fe_{1,9}$), ayant les dimensions indiquées plus haut et caractérisé par les propriétés suivantes :

Coefficients magnétostrictifs : $\lambda_{100}=100\cdot10^{-6}$ et $\lambda_{111}=1700\cdot10^{-6}$.
Aimantation à saturation: 1,2 Tesla.
Coefficient d'échange: $1,1\cdot10^{-11}$ J/m.
Valeur du champ magnétique de polarisation $H_p$ : 150 kA/m=1875 Oe.

La valeur absolue des contraintes $|\sigma_{xx}|$ vaut 100 Mpa, comme évaluée à l'aide de la simulation mécanique.

Les résultats des simulations (figures 4A et 4B) montrent que, quel que soit l'état initial de l'aimantation, l'application d'une tension de -0,4V réoriente l'aimantation suivant l'axe -X (état $P_1$), alors qu'une tension de +0,4V réoriente l'aimantation suivant l'axe +Y (état $P_2$). A la suppression de la commande, l'aimantation reste dans l'état nouvellement défini : les simulations montrent que le système reste stabilisé dans le nouveau minimum local d'énergie.

L'élément magnétique ELM peut présenter une forme autre qu'ellipsoïdale, par exemple en rectangle, losange, « L », ou toute autre forme susceptible d'induire une inhomogénéité magnétique « de forme ».

L'anisotropie magnétique, d'ailleurs, ne doit pas nécessairement être, ou être exclusivement, d'origine géométrique. Elle peut aussi être due à la structure microscopique de l'élément. Une anisotropie de ce type est présente naturellement dans certains matériaux cristallins. Elle peut aussi être obtenue dans les matériaux polycristallins ou amorphes, par exemple en fabriquant l'élément magnétique par dépôt dans un champ magnétique externe. Cette anisotropie microstructurelle peut être combinée avec une anisotropie de forme, ou être utilisée seule. Dans ce dernier cas, l'élément magnétique peut même présenter une forme circulaire.

Il n'est pas indispensable que l'élément magnétique soit constitué d'un seul domaine magnétique, même si cela est généralement préféré. En tout cas, l'élément magnétique devrait présenter des petites dimensions, de préférence inférieures à 1μm, voire inférieures ou égales à 100 nm, afin d'optimiser la densité de stockage de l'information.

L'élément magnétique peut être réalisé en un seul matériau et présenter une structure homogène, ou bien être micro- ou nanostructuré et/ou avoir une structure composite, par exemple de type multicouche.

Comme cela a été expliqué plus haut, l'« élément magnétique » peut être réalisé en tout matériau susceptible de présenter un ordre magnétique même en l'absence d'un champ magnétique externe. Il peut notamment s'agir d'un matériau ferromagnétique, ferrimagnétique, spérimagnétique voire même antiferromagnétique. Tous ces matériaux présentent un effet magnétoélastique ou magnétostrictif plus ou moins intense. En pratique, pour un bon fonctionnement de l'invention, cet effet ne devrai pas être trop faible ; en particulier, un matériau utilisé pour la mise en oeuvre de l'invention devrait présenter un coefficient magnétostrictif $b^{\gamma,2}$ supérieur ou égal à 1Mpa, et de préférence supérieur ou égal à 10 MPa, au moins le long d'un axe. Le Terfenol est spécialement indiqué en raison de ses coefficients magnétostrictifs particulièrement importants.

Comme cela a été mentionné plus haut, le champ de polarisation magnétique ne doit pas nécessairement être un champ magnétique au sens propre ; il peut aussi s'agir d'un « champ magnétique équivalent », dû à des interactions d'échange.

Si le champ de polarisation magnétique est effectivement de nature magnétique, il peut être généré par une ou plusieurs bobines ($B_1$, $B_2$), autres conducteurs parcourus de courant, ou aimants permanents (figure 5A). Il pourra également s'agir d'un « champ de fuite » généré par une couche de polarisation magnétique (aimant permanent) CPM disposée au-dessous (ou au-dessus) de l'élément ELM et séparé de ce dernier par une couche séparatrice CS ayant une épaisseur généralement supérieure à 10 nm (figure 5B). Une polarisation d'échange peut être obtenue grâce à une couche de polarisation d'échange CPE disposée au-dessous (ou au-dessus) de l'élément ELM et séparé de ce dernier par une couche séparatrice CS' ayant une épaisseur de l'ordre de 1 - 10 nm ou moins (figure 5C). Les techniques de polarisation par champ magnétique (figures 5A et 5B) peuvent agir sur plusieurs éléments magnétiques en même temps.

Quelle que soit sa nature physique, le champ de polarisation magnétique ne doit pas nécessairement être perpendiculaire à l'axe d'aimantation facile, bien qu'il soit généralement préféré que l'angle entre les axes $a_1$ et $a_2$ soit compris entre 80° et 100°. En revanche, il est essentiel que ces deux axes ne soient pas parallèles entre eux. Le rapport entre l'intensité du champ de polarisation magnétique et celle du champ magnétique équivalent caractérisant l'anisotropie de forme (ou microstructurelle) du matériau magnétique dépend de l'angle entre les axes $a_1$ et $a_2$. Ce rapport doit être choisi de manière à permettre l'existence de deux orientations d'équilibre stables. Dans le cas de l'exemple, où $a_1$ et

$a_2$ sont perpendiculaires entre eux, ce rapport doit être compris entre $\sqrt{2}/2$ et 1.

Comme le montre la figure 3, les deux orientations d'équilibre stable ne sont pas nécessairement alignées avec les axes X et Y. Il n'est pas non plus essentiel qu'elles soient disposées symétriquement de part et d'autre de l'axe $a_2$. En effet, cette symétrie existe seulement si l'axe $a_2$ est perpendiculaire à l'axe $a_1$.

L'axe X d'application des contraintes mécaniques doit être distinct des axes $a_1$ et $a_2$, mais il ne doit pas nécessairement bissecter l'angle formé par ces deux axes.

Le substrat SP ne doit pas nécessairement être piézoélectrique : il peut aussi être électrostrictif. A ce propos, il faut souligner que l'effet électrostrictif est quadratique : il n'est donc pas possible de passer d'une contrainte compressive à une contrainte en traction simplement en inversant la différence de potentiel aux bornes des électrodes. Pour ce faire, il est nécessaire d'utiliser une tension de polarisation $V_0$ à laquelle se superpose le signal $V_p$, moins intense. Dans ces conditions, le matériau électrostrictif polarisé peut être caractérisé par un coefficient piézoélectrique « équivalent ».

En fait, tous les matériaux diélectriques sont plus au moins électrostrictifs, mais en pratique seuls des matériaux piézoélectriques ou électrostrictifs présentant un coefficient piézoélectrique équivalent suffisamment élevé (50 pm/V ou plus, au moins le long d'un axe) pourront être utilisés en pratique avec des résultats satisfaisants.

Ce qui est essentiel pour le fonctionnement de l'élément de mémoire de l'invention est qu'une modification du champ de contraintes mécaniques auquel est soumis l'élément magnétique, obtenue par voie électrique, induise un changement de son état magnétique. La modification du champ de contrainte mécanique peut être autre qu'un simple changement de signe, comme dans l'exemple. Elle peut être obtenue en utilisant une configuration d'électrodes autre que celle de la figure 1.

L'élément magnétique ELM peut être encastré dans le substrat SP, comme dans l'exemple, ou être déposé sur sa surface. D'autres formes de couplage mécanique peuvent aussi être envisagées. Ces options ne sont pas toujours équivalentes. Lorsque l'élément magnétique ELM est conducteur, il est préférable qu'il ne soit pas simplement être déposé sur la surface du substrat, car un tel agencement conduit à la courbure des lignes de champ électrique dans le substrat et à l'annulation ou, au moins, à une forte réduction, des contraintes mécaniques. Les figures 6A - 6D montrent quatre configurations possibles pour un élément magnétique conducteur, et les lignes de champ électriques correspondantes :

- Figure 6A : élément magnétique encastré, électrodes enterrées : pas de courbure des lignes de champ, configurations favorable.
- Figure 6B : élément magnétique encastré, électrodes simplement déposées : pas de courbure des lignes de champ, configurations favorable.
- Figure 6C : élément magnétique simplement déposé, électrodes enterrées : courbure importante des lignes de champ, configurations défavorable.
- Figure 6D : élément magnétique simplement déposé, électrodes simplement déposées : courbure importante des lignes de champ, configurations défavorable.

Les configurations des figures 6C et 6D peuvent en revanche être utilisées avec profit dans le cas d'un élément magnétique non conducteur, n'induisant pas de courbure des lignes de champ.

Le cas d'un élément magnétique conducteur est particulièrement important, car les meilleurs matériaux magnétostrictifs connus actuellement sont les composés de type Tb-TM ou Sm-TM où TM représente un alliage de métaux de transition.

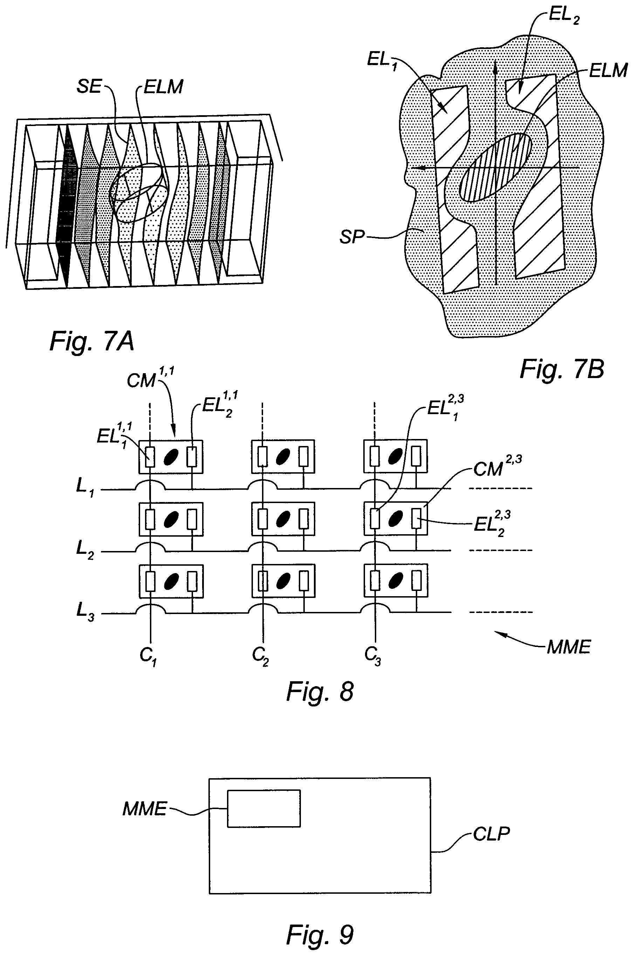

Pour diminuer l'encombrement de la cellule de mémoire, il faut pouvoir rapprocher les électrodes de l'élément magnétique. On adaptera alors leur forme pour garder une forme des lignes de champ électrique dans le matériau piézoélectrique ou électrostrictif compatible avec la génération des contraintes anisotropes dans le plan. Une bonne solution est de considérer des électrodes suivant la forme des surfaces équipotentielles qui seraient engendrées par des électrodes planes situées à une grande distance de l'élément magnétique. De telles surfaces équipotentielles SE sont illustrées sur la figure 7A. La figure 7B montre des électrodes $EL_1$, $EL_2$ ayant la forme d'équipotentielles ; on peut considérer qu'elles épousent la forme de l'élément magnétique ELM.

Plusieurs cellules de mémoire $CM^{1,1}...CM^{2,3}...$ peuvent être agencées dans une structure matricielle par lignes et colonnes pour former une mémoire non-volatile à accès direct MME, comme représenté sur la figure 8. Sur cette figure, la référence « $CM^{2,3}$ indique la cellule de mémoire située au croisement de la deuxième ligne et de la troisième colonne de la matrice. Chaque cellule de mémoire présente une première et une deuxième électrode ($EL_1^{2,3}$ et $EL_1^{2,3}$ dans le cas de la cellule $CM^{2,3}$). Toutes les « premières électrodes » des cellules d'une même colonne sont connectées électriquement entre elles par l'intermédiaire de conducteurs respectifs $C_1$, $C_2$, $C_3$ ... De la même façon, toutes les « deuxièmes électrodes » des cellules d'une même ligne sont connectées électriquement entre elles par l'intermédiaire de conducteurs respectifs $L_8$, $L_2$, $L_3$ ... Il est facile de se rendre compte du fait que pour enregistrer un « 1 » ou un « 0 » logique dans la cellule $CM^{i,j}$ il suffit d'appliquer une différence de potentiel du signe opportun et pour une durée adéquate

entre les conducteurs $L_i$ et $C_j$. Un deuxième jeu de lignes $L'_i$, $C'_j$ peut être utilisé pour connecter les capteurs des différentes cellules, formant ainsi une structure matricielle de lecture.

Selon une variante illustrée schématiquement sur la figure 10, il est possible de prévoir une mémoire à structure matricielle dans laquelle les éléments magnétiques, étant conducteurs, servent en même temps d'électrodes pour d'autres éléments de mémoire. Ainsi, dans l'exemple de la figure 10, les éléments magnétiques conducteurs ELM1 et ELM3, connectés par l'intermédiaires de leurs contacts « de lecture » (références $CE_1$, $CE_2$ sur les schémas des figures 12 - 14), servent d'électrodes pour l'application d'une différence de potentiel au matériau piézoélectrique entourant l'élément ELM2 ; de même, les éléments ELM2 et ELM4 servent d'électrodes pour l'application d'une différence de potentiel au matériau piézoélectrique entourant l'élément ELM3, et ainsi de suite. La structure est beaucoup plus simple que celle de la figure 8 : il ne faut pas prévoir des électrodes en tant qu'éléments séparés (sauf aux extrémités de l'alignement d'éléments magnétiques : électrode $EL_1$ à la gauche de ELM1 et électrode EL2 à la droite de ELM4), et un même jeu de lignes électriques peut servir tant pour la lecture que pour l'écriture.

La mémoire MME peut être utilisée comme support de stockage de masse, ou pour d'autres applications. Par exemple, elle peut servir à stocker la configuration logique d'un circuit logique programmable, comme cela est représenté schématiquement sur la figure 9. Sa vitesse de commutation est de l'ordre de la nanoseconde, comme dans les FeRam (mémoires ferroélectriques). Une taille des cellules de l'ordre de 50 nm x 50 nm parait réaliste, ce qui conduit à une capacité d'environ 40 Gbits/cm$^2$. Un des avantages majeurs de la technologie de l'invention réside dans sa faible consommation, et donc dissipation thermique, qui favorise une intégration verticale par superposition de plusieurs couches constituées chacune par une matrice de cellules de mémoire.

## Revendications

1. Elément de mémoire magnétoélectrique comprenant :

   - un élément magnétique (ELM) présentant un seul axe d'aimantation facile aligné le long d'un premier axe ($a_1$) ;
   - un moyen ($B_1$, $B_2$, PM, CPE) pour appliquer audit élément magnétique un champ de polarisation magnétique ($H_p$) aligné le long d'un deuxième axe ($a_2$) non parallèle audit premier axe, l'intensité dudit champ étant choisie de telle manière que l'élément magnétique présente, par l'effet combiné dudit champ et dudit axe d'aimantation facile, deux états distincts d'équilibre stable de son aimantation ($P_1$, $P_2$), correspondant à deux directions d'aimantation différentes, qui ne sont pas opposées entre elles ;
   - un substrat (SP) piézoélectrique ou électrostrictif couplé mécaniquement avec ledit élément magnétique ; et
   - au moins une première ($EL_1$) et une deuxième ($EL_2$) électrode, agencées pour appliquer un champ électrique au substrat piézoélectrique ou électrostrictif de telle manière que ledit substrat exerce sur ledit élément magnétique une contrainte mécanique non isotrope, de direction principale orientée selon un troisième axe (OX), coplanaire mais distinct desdits premier et deuxième axes, ladite contrainte mécanique étant suffisamment intense pour induire, par couplage magnétostrictif, une commutation de l'état d'aimantation dudit élément magnétique entre les deux dits états d'équilibre stable.

2. Elément de mémoire magnétoélectrique selon la revendication 1, dans lequel ledit élément magnétique est constitué d'un seul domaine magnétique.

3. Elément de mémoire magnétoélectrique selon l'une des revendications précédentes dans lequel ledit élément magnétique présente une forme allongée, déterminant en tout ou en partie ledit axe d'aimantation facile par anisotropie de forme.

4. Elément de mémoire magnétoélectrique selon l'une des revendications précédentes dans lequel ledit élément magnétique présente une structure microscopique anisotrope déterminant en tout ou en partie ledit axe d'aimantation facile.

5. Elément de mémoire magnétoélectrique selon la revendication 4 dans lequel ladite structure microscopique anisotrope est obtenue en fabriquant ledit élément par dépôt en présence d'un champ magnétique externe.

6. Elément de mémoire magnétoélectrique selon l'une des revendications précédentes comportant un moyen ($B_1$, $B_2$, CPM) pour générer ledit champ de polarisation magnétique sous la forme d'un champ magnétique externe.

7. Elément de mémoire magnétoélectrique selon l'une des revendications précédentes comportant un moyen (CPE) pour générer ledit champ de polarisation magnétique sous la forme d'un champ d'échange.

8. Elément de mémoire magnétoélectrique selon l'une des revendications précédentes comportant un moyen pour générer un dit champ de polarisation magnétique sensiblement perpendiculaire audit axe d'aimantation facile.

9. Elément de mémoire magnétoélectrique selon la revendication 8, dans lequel lesdites électrodes sont agencées de telle manière que ledit substrat exerce sur ledit élément magnétique une contrainte mécanique non isotrope formant un angle moyen compris entre 40° et 50°, et de préférence d'environ 45°, aussi bien avec ledit axe d'aimantation facile qu'avec ledit champ de polarisation magnétique.

10. Elément de mémoire magnétoélectrique selon l'une des revendications précédentes, dans lequel lesdites électrodes épousent la forme de l'élément magnétique.

11. Elément de mémoire magnétoélectrique selon l'une des revendications précédentes dans lequel ledit élément magnétique est encastré dans ledit substrat.

12. Elément de mémoire magnétoélectrique selon l'une des revendications 1 à 10 dans lequel ledit élément magnétique est déposé sur ledit substrat.

13. Cellule de mémoire comprenant un élément de mémoire magnétoélectrique selon l'une des revendications précédentes et un capteur magnétique (ML) pour déterminer la direction de l'aimantation dudit élément magnétique,

14. Cellule de mémoire selon la revendication 13 dans laquelle ledit capteur est choisi parmi : un capteur à effet Hall et un capteur à magnétorésistance, magnétorésistance à effet tunnel, magnétorésistance géante ou magnétorésistance colossale.

15. Mémoire non-volatile à accès direct (MME) comprenant une pluralité de cellules de mémoire ($CM^{11}$, $CM^{2,3}$) selon l'une des revendications 13 ou 14 agencées selon un schéma matriciel par lignes et par colonnes, les premières électrodes des cellules d'une même colonne étant reliées électriquement entre elles, ainsi que les deuxièmes électrodes des cellules d'une même ligne.

16. Circuit logique programmable (CLP) comprenant une pluralité de cellules de mémoire selon l'une des revendications 13 ou 14 en tant que moyen de stockage d'une configuration logique.

17. Dispositif mémristif comprenant :

   - un élément magnétique (ELM) présentant un seul axe d'aimantation facile aligné le long d'un premier axe ($a_1$) ;
   - un moyen ($B_1$, $B_2$, PM, CPE) pour appliquer audit élément magnétique un champ de polarisation magnétique ($H_p$) aligné le long d'un deuxième axe ($a_2$) non parallèle audit premier axe, l'intensité dudit champ étant choisie de telle manière que l'élément magnétique présente, par l'effet combiné dudit champ et dudit axe d'aimantation facile, deux états d'équilibre stable de son aimantation ($P_1$, $P_2$), correspondant à des directions d'aimantation formant entre elles un angle $0 \leq \alpha < 90°$;
   - un substrat (SP) piézoélectrique ou électrostrictif couplé mécaniquement avec ledit élément magnétique ;
   - au moins une première ($EL_1$) et une deuxième ($EL_2$) électrode, agencées pour appliquer un champ électrique au substrat piézoélectrique ou électrostrictif de telle manière que ledit substrat exerce sur ledit élément magnétique une contrainte mécanique non isotrope, de direction principale généralement orientée selon un troisième axe (OX), coplanaire mais distinct desdits premier et deuxième axes ; et
   - un capteur magnétique (ML) présentant deux terminaux ($CE_1$, $CE_2$), la résistance électrique entre les deux dits terminaux dépendant de la direction de l'aimantation dudit élément magnétique.

18. Dispositif mémristif selon la revendication 17, dans lequel les deux dits états d'équilibre stable de son aimantation ($P_1$, $P_2$) coïncident, les directions d'aimantation correspondantes formant entre elles un angle $\alpha = 0°$.

**Patentansprüche**

1. Magnetoelektrisches Speicherelement, umfassend:

   - ein Magnetelement (ELM), das eine einzige Vorzugsrichtung der Magnetisierung aufweist, die entlang einer ersten Achse ($a_1$) ausgerichtet ist;

- ein Mittel ($B_1$, $B_2$, PM, CPE) zum Aufbringen eines magnetischen Polarisationsfeldes ($H_p$) auf das Magnetelement, das entlang einer zweiten, nicht parallel zu der ersten Achse vorgesehenen Achse ($a_2$) ausgerichtet ist, wobei die Intensität des Feldes derart gewählt ist, dass das Magnetelement durch die kombinierte Wirkung des Feldes und der Vorzugsachse der Magnetisierung zwei unterschiedliche Zustände des stabilen Gleichgewichts seiner Magnetisierung ($P_1$, $P_2$) aufweist, die zwei unterschiedlichen Magnetisierungsrichtungen entsprechen, die nicht untereinander entgegengesetzt sind;

- ein piezoelektrisches oder elektrostriktives Substrat (SP), das mechanisch mit dem Magnetelement gekoppelt ist, und

- mindestens eine erste ($EL_1$) und eine zweite ($EL_2$) Elektrode, die ausgebildet sind, ein elektrisches Feld auf das piezoelektrische oder elektrostriktive Element derart aufzubringen, dass das Substrat auf das Magnetelement eine nicht isotrope mechanische Belastung von einer Hauptrichtung ausübt, die gemäß einer dritten Achse (OX), koplanar aber unterschiedlich zu der ersten und zweiten Achse, orientiert ist, wobei die mechanische Belastung ausreichend stark ist, um durch magnetostriktive Koppelung eine Umschaltung des Magnetzustandes des Magnetelementes zwischen den zwei besagten Zuständen des stabilen Gleichgewichts zu induzieren.

2. Magnetoelektrisches Speicherelement nach Anspruch 1, bei dem das Magnetelement aus einer einzigen Magnetdomäne gebildet ist.

3. Magnetoelektrisches Speicherelement nach einem der vorhergehenden Ansprüche, bei dem das Magnetelement eine langgestreckte Form aufweist, die insgesamt oder teilweise die Vorzugsrichtung der Magnetisierung durch Form-Anisotropie bestimmt.

4. Magnetoelektrisches Speicherelement nach einem der vorhergehenden Ansprüche, bei dem das Magnetelement eine mikroskopische anisotrope Struktur aufweist, die insgesamt oder teilweise die Vorzugsrichtung der Magnetisierung bestimmt.

5. Magnetoelektrisches Speicherelement nach Anspruch 4, bei dem die mikroskopische anisotrope Struktur dadurch erhalten wird, dass das Element durch Abscheidung bei Vorhandensein eines äußeren Magnetfeldes hergestellt wird.

6. Magnetoelektrisches Speicherelement nach einem der vorhergehenden Ansprüche, ein Mittel ($B_1$, $B_2$, CPM) zum Erzeugen des magnetischen Polarisationsfeldes in der Form eines äußeren Magnetfeldes aufweisend.

7. Magnetoelektrisches Speicherelement nach einem der vorhergehenden Ansprüche, ein Mittel (CPE) zum Erzeugen des magnetischen Polarisationsfeldes in der Form eines Austauschfeldes aufweisend.

8. Magnetoelektrisches Speicherelement nach einem der vorhergehenden Ansprüche, ein Mittel zum Erzeugen eines besagten magnetischen Polarisationsfeldes im Wesentlichen senkrecht zur Vorzugsrichtung der Magnetisierung aufweisend.

9. Magnetoelektrisches Speicherelement nach Anspruch 8, bei dem die Elektroden derart angeordnet sind, dass das Substrat auf das Magnetelement eine mechanische nicht isotrope Belastung ausübt, die einen mittleren Winkel zwischen 40 und 50 Grad und vorzugsweise ungefähr 45 Grad bildet sowohl mit der Vorzugsrichtung der Magnetisierung als auch mit dem magnetischen Polarisationsfeld.

10. Magnetoelektrisches Speicherelement nach einem der vorhergehenden Ansprüche, bei dem die Elektroden an die Form des Magnetelements angepasst sind.

11. Magnetoelektrisches Speicherelement nach einem der vorhergehenden Ansprüche, bei dem das Magnetelement in das Substrat eingelassen ist.

12. Magnetoelektrisches Speicherelement nach einem der Ansprüche 1 bis 10, bei dem das Magnetelement auf dem Substrat abgeschieden ist.

13. Speicherzelle, ein magnetoelektrisches Speicherelement nach einem der vorhergehenden Ansprüche und einen Magnetsensor (ML) zum Bestimmen der Richtung der Magnetisierung des Magnetelementes umfassend.

14. Speicherzelle nach Anspruch 13, bei dem der Sensor ausgewählt ist aus: einem Hallsensor und einem Magnetowiderstand-Sensor, einem Tunneleffekt- Magnetowiderstand-Sensor, einem GMR-Sensor oder Sensor auf Basis des kolossalen magnetoresistiven Effekts.

15. Nicht flüchtiger Speicher mit direktem Zugriff (MME), eine Mehrzahl von Speicherzellen (CM$^{11}$, CM$^{2,3}$) nach einem der Ansprüche 13 oder 14 umfassend, die gemäß einem Matrixschema durch Zeilen und Spalten angeordnet sind, wobei die ersten Elektroden der Zellen einer selben Spalte ebenso wie die zweiten Elektroden der Zellen einer selben Zeile elektrisch untereinander verbunden sind.

16. Programmierbarer logischer Schaltkreis (CLP), der einer Mehrzahl von Speicherzellen nach einem der Ansprüche 13 oder 14 umfasst, als Speichermittel einer logischen Konfiguration.

17. Memrestive Vorrichtung, umfassend:

- ein Magnetelement (ELM), das eine einzige Vorzugsrichtung der Magnetisierung aufweist, die entlang einer ersten Achse ($a_1$) ausgerichtet ist,
- ein Mittel ($B_1$, $B_2$, PM, CPE) zum Aufbringen eines magnetischen Polarisationsfeldes ($H_p$) auf das Magnetelement, das entlang einer zweiten Achse ($a_2$), die nicht parallel zur ersten Achse ist, ausgerichtet ist, wobei die Intensität des Feldes derart gewählt ist, dass das Magnetelement durch die kombinierte Wirkung des Feldes und der Vorzugsrichtung der Magnetisierung zwei stabile Gleichgewichtszustände seiner Magnetisierung ($P_1$, $P_2$) entsprechend den zwei Magnetisierungsrichtungen, die untereinander einen Winkel $0 \leq \alpha < 90°$ bilden, aufweist;
- ein piezoelektrisches oder elektrostriktives Substrat (SP), das mechanisch mit dem Magnetelement gekoppelt ist;
- mindestens eine erste ($EL_1$) und eine zweite ($EL_2$) Elektrode, die ausgebildet sind, ein elektrisches Feld auf das piezoelektrische oder elektrostriktive Substrat derart aufzubringen, dass das Substrat auf das Magnetelement eine nicht isotrope mechanische Belastung in einer Hauptrichtung ausübt, die allgemein gemäß einer dritten Achse (OX), koplanar, aber unterschiedlich zu der ersten und zweiten Achse orientiert ist; und
- einen Magnetsensor (ML), der zwei Anschlüsse ($CE_1$, $CE_2$) aufweist, wobei der elektrische Widerstand zwischen den zwei genannten Anschlüssen von der Richtung der Magnetisierung des Magnetelementes abhängt.

18. Memrestive Vorrichtung nach Anspruch 17, bei der die zwei genannten stabilen Gleichgewichtszustände ihrer Magnetisierung ($P_1$, $P_2$) übereinstimmen, wobei die korrespondierenden Magnetisierungsrichtungen untereinander einen Winkel $\alpha = 0°$ bilden.

**Claims**

1. Magnetoelectric memory element comprising:

- a magnetic element (ELM) having a single simple magnetisation axis aligned along a first axis ($a_1$);
- a means ($B_1$, $B_2$, PM, CPE) for applying to said magnetic element a magnetic polarisation field ($H_p$) aligned along a second axis ($a_2$) which is non-parallel to said first axis, the intensity of said field being chosen such that the magnetic element has, due to the combined effect of said field and of said simple magnetisation axis, two different, stable equilibrium states of its magnetisation ($P_1$, $P_1$), corresponding to two different magnetisation directions, which are not opposite to each other;
- a piezoelectric or electrostrictive substrate (SP) coupled mechanically to said magnetic element; and
- at least one first ($EL_1$) and one second ($EL_2$) electrode, disposed in order to apply an electrical field to the piezoelectric or electrostrictive substrate such that said substrate exerts on said magnetic element a non-isotropic mechanical stress with main direction orientated according to a third axis (OX), coplanar but different from said first and second axes, said mechanical stress being sufficiently intense to cause, by magnetostrictive coupling, a commutation of the magnetisation state of said magnetic element between the two said stable equilibrium states.

2. Magnetoelectric memory element according to claim 1, in which said magnetic element consists of a single magnetic domain.

3. Magnetoelectric memory element according to one of the preceding claims, in which said magnetic element has an elongated shape, determining wholly or in part said simple magnetisation axis by shape anisotropy.

4. Magnetoelectric memory element according to one of the preceding claims, in which said magnetic element has an anisotropic microscopic structure determining wholly or in part said simple magnetisation axis.

5. Magnetoelectric memory element according to claim 4, in which said anisotropic microscopic structure is obtained by manufacturing said element by deposition in the presence of an external magnetic field.

6. Magnetoelectric memory element according to one of the preceding claims comprising a means ($B_1$, $B_2$, CPM) for generating said magnetic polarisation field in the form of an external magnetic field.

7. Magnetoelectric memory element according to one of the preceding claims comprising a means (CPE) for generating said magnetic polarisation field in the form of an exchange field.

8. Magnetoelectric memory element according to one of the preceding claims, comprising a means for generating a said magnetic polarisation field which is essentially perpendicular to said simple magnetisation axis.

9. Magnetoelectric memory element according to claim 8, in which said electrodes are disposed such that said substrate exerts on said magnetic element a non-isotropic mechanical stress forming an average angle between 40° and 50°, and preferably approximately 45°, both with said simple magnetisation axis and with said magnetic polarisation field.

10. Magnetoelectric memory element according to one of the preceding claims, in which said electrodes assume the shape of the magnetic element.

11. Magnetoelectric memory element according to one of the preceding claims, in which said magnetic element is embedded in said substrate.

12. Magnetoelectric memory element according to one of the claims 1 to 10, in which said magnetic element is deposited on said substrate.

13. Memory cell comprising a magnetoelectric memory element according to one of the preceding claims and a magnetic sensor (ML) for determining the magnetisation direction of said magnetic element.

14. Memory cell according to claim 13, in which said sensor is chosen from: a Hall effect sensor and a magnetoresistance sensor, a tunnel effect magnetoresistance, a giant magnetoresistance or colossal magnetoresistance.

15. Non-volatile direct access memory (MME) comprising a plurality of memory cells ($CM^{11}$, $CM^{2,3}$) according to one of the claims 13 or 14, disposed according to a matrix scheme by lines and by columns, the first electrodes of the cells of the same column being connected electrically to each other and also the second electrodes of the cells of the same line.

16. Programmable logic circuit (CLP) comprising a plurality of memory cells according to one of the claims 13 or 14 as storage means of a logic configuration.

17. Memristive device comprising:

 - a magnetic element (ELM) having a single simple magnetisation axis aligned along a first axis ($a_1$);
 - a means ($B_1$, $B_1$, PM, CPE) for applying to said magnetic element a magnetic polarisation field ($H_p$) aligned along a second axis ($a_2$) which is non-parallel to said first axis, the intensity of said field being chosen such that the magnetic element has, due to the combined effect of said field and of said simple magnetisation axis, two stable equilibrium states of its magnetisation ($P_1$, $P_2$) which correspond to magnetisation directions forming together an angle $0 \leq \alpha < 90°$;
 - a piezoelectric or electrostrictive substrate (SP) coupled mechanically to said magnetic element;
 - at least one first ($EL_1$) and one second ($EL_2$) electrode, disposed in order to apply an electrical field to the piezoelectric or electrostrictive substrate such that said substrate exerts on said magnetic element a non-isotropic mechanical stress with main direction generally orientated according to a third axis (OX), coplanar but different from said first and second axes; and
 - a magnetic sensor (ML) having two terminals ($CE_1$, $CE_2$), the electrical resistance between the two said terminals depending upon the magnetisation direction of said magnetic element.

**18.** Memristive device according to claim 17, in which the two said stable equilibrium states of its magnetisation ($P_1$, $P_2$) coincide, the corresponding magnetisation directions forming together an angle $\alpha = 0°$.

Fig. 1

Fig. 2

Fig. 3

Fig. 4A

Fig. 4B

Fig. 5A

Fig. 5B

Fig. 5C

Fig. 6A

Fig. 6C

Fig. 6B

Fig. 6D

Fig. 7A

Fig. 7B

Fig. 8

Fig. 9

EL$_1$   ELM$_1$   ELM$_2$   ELM$_3$   ELM$_4$   *Fig. 10*

SP

EL$_2$

*Fig. 11*

CE$_1$
CMF
CB
ELM
CE$_2$

*Fig. 12*

Fig. 13

Fig. 14

Fig. 15A

Fig. 15B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6339543 B

- EP 2015307 A

**Littérature non-brevet citée dans la description**

- **MARK H. KRYDER ; CHANG SOO KIM.** After Hard Drives-What Comes Next?. *IEEE Transactions on Magnetics,* Octobre 2009, vol. 45 (10), 3406-3413
- **V. NOVOSAD et al.** Novel magnetostrictive memory device. *J. Appl. Phys.,* 01 Mai 2000, vol. 87 (9
- **M. OVERBY et al.** GaMnAs-based hybrid multiferroic memory device. *Applied Physics Letters,* 2008, vol. 92, 192501

- **E. DU TRÉMOLET DE LACHAISSERIE ; J. C. PEUZIN.** Magnétostriction and internal stresses in thin films: the cantilever method revisited. *Journal of Magnetism and Magnetic Materials,* 1994, vol. 136, 189-196
- **E. DU TRÉMOLET DE LACHAISSERIE.** Définition and measurement of the surface magnetoelastic coupling coefficients in thin films multilayers. *Phys. Rev. B,* 1995, vol. 51 (22), 15925-15932